(19)

Europäisches Patentamt
European Patent Office
Office européen des brevets

(11) **EP 2 105 754 A2**

## (12) EUROPEAN PATENT APPLICATION

(43) Date of publication:
**30.09.2009 Bulletin 2009/40**

(51) Int Cl.:
***G01R 31/36*** (2006.01)   *H02J 7/00* (2006.01)

(21) Application number: **09002858.0**

(22) Date of filing: **27.02.2009**

| | |
|---|---|
| (84) Designated Contracting States:<br>**AT BE BG CH CY CZ DE DK EE ES FI FR GB GR HR HU IE IS IT LI LT LU LV MC MK MT NL NO PL PT RO SE SI SK TR**<br>Designated Extension States:<br>**AL BA RS**<br><br>(30) Priority: **28.03.2008 JP 2008085243** | (71) Applicant: **MITSUBISHI JIDOSHA KOGYO KABUSHIKI KAISHA**<br>**Tokyo (JP)**<br><br>(72) Inventor: **Tominaga, Yuki**<br>**Tokyo (JP)**<br><br>(74) Representative: **Vossius & Partner**<br>**Siebertstraße 4**<br>**81675 München (DE)** |

### (54) Remaining battery capacity display method and remaining battery capacity display unit

(57)   A method of displaying a remaining battery capacity of a battery pack including battery cells, includes: monitoring at least voltage of the battery cells; outputting voltage information on the voltage; determining whether or not the battery pack is fully charged; when it is determined that the battery pack is fully charged, defining a lowest-voltage battery cell among the battery cells; estimating a charging rate of the lowest-voltage battery cell at a time when the battery pack is fully charged based on a charging rate map and the voltage information; calculating a correction coefficient for making a correction so that the estimated charging rate becomes a maximum value of the remaining battery capacity at a time when the remaining battery capacity is displayed; calculating a charging rate to be displayed, based on a charging rate at the time when the remaining battery capacity is displayed and the correction coefficient; and displaying the calculated charging rate on a display.

FIG.1

EP 2 105 754 A2

**Description**

This invention relates to a remaining battery capacity display method and a remaining battery capacity display unit.

A battery pack of a lithium ion secondary battery installed in an electric car, a hybrid car, etc., includes a plurality of battery cells connected in series to provide any desired electromotive force. If the battery pack including a plurality of battery cells is repeatedly charged and discharged, variations in the advance degree of degradation of each battery cell occur due to the temperature environment difference, the individual difference, etc., caused by the installation position difference in the battery pack. Therefore, as the battery pack is repeatedly charged and discharged, the voltage varies from one battery cell to another.

The characteristic of a battery pack using a lithium ion secondary battery will be discussed.

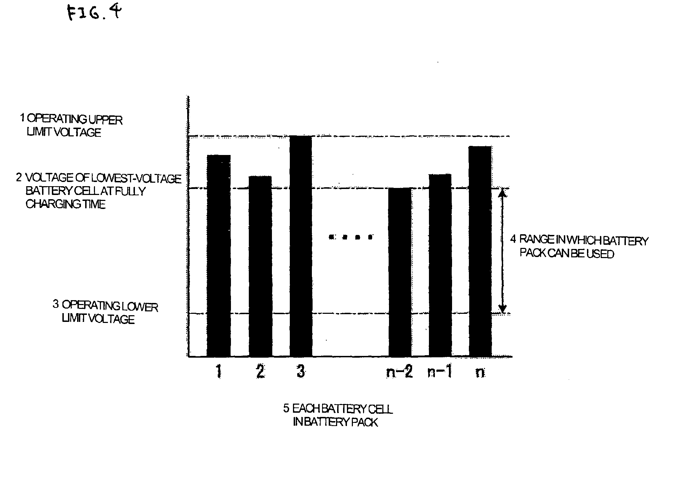

FIG. 4 is a drawing to show the voltage of each battery cell when a battery pack using a lithium ion secondary battery is fully charged.

As shown in FIG. 4, each of the battery cells included in the battery pack of the lithium ion secondary battery involves an operating upper limit voltage and an operating lower limit voltage. If the battery cell is charged exceeding the operating upper limit voltage or is discharged below the operating lower limit voltage, the battery cell is remarkably degraded and the life is shortened; this is a problem.

Thus, to charge a battery pack of a lithium ion secondary battery, there is the following related-art method. At the charging time, charging the battery pack is completed when the voltage of one battery cell reaches the operating upper limit voltage so that the voltage of each battery cell always falls within a value between the operating upper limit voltage and the operating lower limit voltage by a battery management unit (BMU) for monitoring the battery pack, and at this point in time, it is assumed that the battery pack is fully charged.

The battery cell of the highest voltage among the battery cells in the battery pack will be hereinafter referred to as highest-voltage battery cell (for example, the third cell battery in FIG. 4).

By the way, in an electric car, a hybrid car, etc., how much the remaining capacity of the battery pack is, namely, how much the battery pack can be used may be displayed for the driver as the remaining battery capacity. To display the remaining battery capacity of a battery pack, there is the following related-art display method of the remaining battery capacity. The charging rate calculated based on the voltage of the battery cell of the lowest voltage among the battery cells in the battery pack at the full charging time (which will be hereinafter referred to as lowest-voltage battery cell (for example, the "n-2"nd cell battery in FIG. 4)) is displayed as the remaining battery capacity of the battery pack.

In the display method of the remaining battery capacity in the related art as described above, if the remaining battery capacity of the battery pack is displayed using the charging rate of any other battery cell than the lowest-voltage battery cell, the lowest-voltage battery cell reaches the lowest usable voltage in the usable range before any other battery cell than the lowest-voltage battery cell reaches the lowest usable voltage in the usable range. Thus, the remaining battery capacity display of the battery pack when use of the battery pack is stopped by the BMU does not become the lowest value in some cases. Japanese Patent No. 3390559 discloses an example of a remaining battery capacity display unit in a related art.

However, in the display method of the remaining battery capacity of the battery pack in the related art described above, the charging rate calculated based on the voltage of the lowest-voltage battery cell is displayed as the remaining battery capacity. Thus, if a voltage difference occurs among the voltages of the battery cells included in the battery pack, there is a possibility that the remaining battery capacity display when the battery pack is fully charged will not become the maximum value. As the voltage difference among the battery cells becomes larger, the remaining battery capacity display indicates a value more distant from the maximum value. Although the battery pack is charged taking a time seemingly sufficient for full charging, if the remaining battery capacity display does not indicate the maximum value, it is feared that the user may be dissatisfied at the vehicle.

It is therefore an object of the invention to provide a remaining battery capacity display method and a remaining battery capacity display unit capable of always displaying the remaining battery capacity of the battery pack at the full charging determination time can as the maximum value of a remaining battery capacity meter.

In order to achieve the object, according to the invention, there is provided a method of displaying a remaining battery capacity of a battery pack including a plurality of battery cells connected in series, the method comprising:

monitoring at least voltage of each of the plurality of battery cells;
outputting voltage information on the monitored voltage;
when the battery pack is charged, determining whether or not the battery pack is fully charged;
when it is determined that the battery pack is fully charged, defining, as a lowest-voltage battery cell, one of the plurality of battery cells which has the lowest voltage among the plurality of battery cells;
estimating a charging rate of the lowest-voltage battery cell at a time when the battery pack is fully charged based on a charging rate map and the voltage information;

calculating a correction coefficient for making a correction so that the estimated charging rate becomes a maximum value of the remaining battery capacity at a time when the remaining battery capacity is displayed;

calculating a charging rate to be displayed, based on a charging rate of the lowest-voltage battery cell at the time when the remaining battery capacity is displayed and the calculated correction coefficient; and

displaying, as the remaining battery capacity of the battery pack, the calculated charging rate on a display.

In order to achieve the obj ect, according to the invention, there is also provided a unit of displaying a remaining battery capacity of a battery pack including a plurality of battery cells connected in series, the unit comprising:

a cell monitor, configured to monitor at least voltage of each of the plurality of battery cells and to output voltage information on the monitored voltage;

a full charging determiner, configured to determine whether or not the battery pack is fully charged when the battery pack is charged; and

a processor:

configured to define, as a lowest-voltage battery cell, one of the plurality of battery cells which has the lowest voltage among the plurality of battery cells when the full charging determiner determines that the battery pack is fully charged;

configured to estimate a charging rate of the lowest-voltage battery cell at a time when the battery pack is fully charged based on a charging rate map and the voltage information;

configured to calculate a correction coefficient for making a correction so that the estimated charging rate becomes a maximum value of the remaining battery capacity at a time when the remaining battery capacity is displayed;

configured to calculate a charging rate to be displayed, based on a charging rate of the lowest-voltage battery cell at the time when the remaining battery capacity is displayed and the calculated correction coefficient; and

configured to display, as the remaining battery capacity of the battery pack, the calculated charging rate on a display.

In the following preferred embodiments of the invention are described with reference to the drawings, in which:

FIG. 1 is a drawing to show the configuration of a part of a remaining battery capacity display unit according to the invention;

FIG. 2 is a drawing to show the configuration of the remaining battery capacity display unit and its peripheral devices according to the invention;

FIG. 3 is a flowchart to show a correction processing procedure of remaining battery capacity display in a remaining battery capacity display method and the remaining battery capacity display unit according to the invention; and

FIG. 4 is a drawing to show the voltage of each battery cell when a battery pack using a lithium ion secondary battery is fully charged.

An embodiment of a remaining battery capacity display method and a remaining battery capacity display unit according to the invention will be discussed with the accompanying drawings.

To begin with, the configuration of the remaining battery capacity display unit and its peripheral devices according to the invention will be discussed.

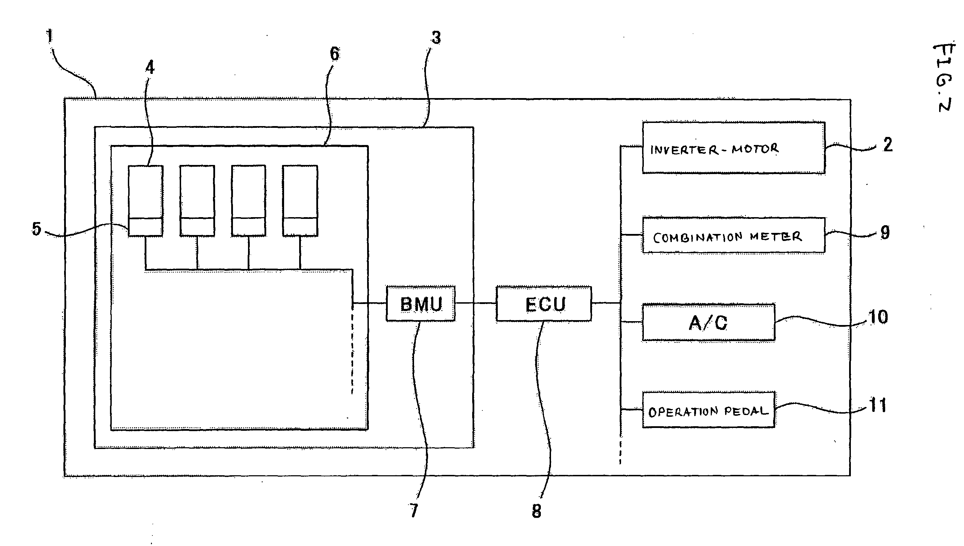

As shown in FIG. 2, in a vehicle 1 such as an electric car or a hybrid car, inverter and motor (which will be hereinafter referred to as inverter-motor) 2 for driving the vehicle 1 is installed. A battery unit 3 for supplying electric power to the inverter-motor 2 is also installed in the vehicle 1.

The battery unit 3 includes a battery pack 6 including a plurality of battery cells 4 and cell monitoring units (CMUs) 5 for monitoring the battery cells 4 and a BMU 7 for controlling the battery pack 6. The battery pack 6 usually is housed in a battery case of a vessel having high rigidity. The battery unit 3 and the inverter-motor 2 are controlled by an electronic control unit (ECU) 8 for mainly controlling the whole vehicle 1.

A combination meter 9 for displaying various pieces of information of the vehicle 1, an air conditioner (A/C) 10, and various devices such as an operation pedal 11 for operating the vehicle 1 are electrically connected to the ECU 8. The ECU 8 acquires various pieces of information of the vehicle 1 from the battery unit 3, the inverter-motor 2, the A/C 10, the operation pedal 11, etc., and controls the battery unit 3, the inverter-motor 2, the combination meter 9, the A/C 10, and the like based on the acquired information so that they operate appropriately.

In the embodiment, the combination meter 9 includes a function for displaying the usable remaining battery capacity of the battery pack. The remaining battery capacity may be displayed according to an analog or digital gage or may be digitally displayed in a numeric value according to the percentage, etc., or may be displayed in any other way.

Next, the configuration of a part of the remaining battery capacity display unit according to the invention will be discussed.

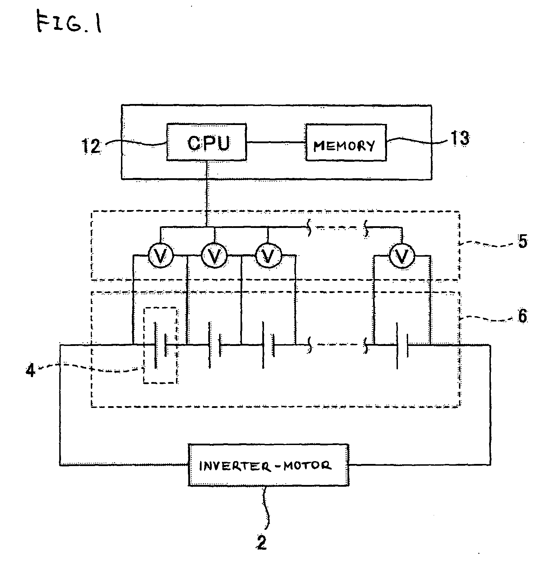

As shown in FIG. 1, the battery pack 6 includes the battery cells 4 connected in series. The CMUs 5 are connected to the battery cells 4 in parallel. They measure the voltage of the battery cells 4, respectively. The CMUs 5 can also measure any other value than the voltage of the battery cells 4, for example, the current, etc.

Each of the CMUs 5 outputs the measured voltage of each of the battery cells 4 to a central processing unit (CPU) 12 for performing correction processing of remaining battery capacity display. The CPU 12 is provided with general-purpose memory 13 that can store various values. In the embodiment, as the CPU 12 and the memory 13, a CPU and memory included in the BMU 7 or the ECU 8 are used, and the CPU and the memory of which the BMU 7 or the ECU 8 to use are selected as required depending on which the BMU 7 or the ECU 8 shoulders the correction processing of remaining battery capacity display.

Next, the correction processing procedure of remaining battery capacity display in the remaining battery capacity display method according to the invention will be discussed.

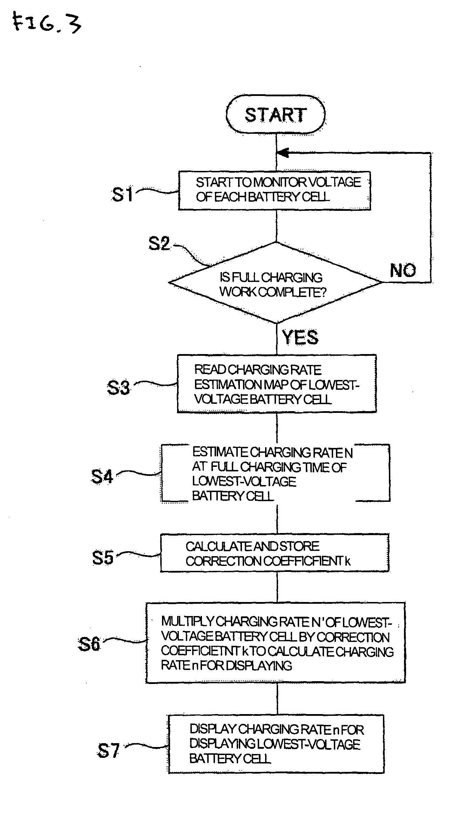

As shown in FIG. 3, first at step S1, the CPU 12 (see FIG. 2) starts to monitor the voltage of each of the battery cells 4 by the CMUs 5. After executing step S1, the CPU 12 executes step S2.

Next, at step S2, the CPU 12 determines whether or not full charging work is complete. If full charging work is complete, the CPU 12 executes step S3. If full charging work is not complete, the CPU 12 again executes step S2.

To determine whether or not full charging work is complete, various methods such as a method of charging as constant-current charge and charging for a predetermined time as constant-voltage charge after the highest-voltage battery cell reaches a predetermined voltage and determining that full charging work is complete, a method of specifying the charging time and determining that full charging work is complete when the predetermined time has elapsed, a method of setting a predetermined electric quantity (Ah) and determining that full charging work is complete when the energized current integration becomes the specified electric quantity, and a method of determining that full charging work is complete when the flowing current reaches a predetermined lower limit value are available, any of which can be selected to determine whether or not full charging work is complete. In this connection, to perform constant-voltage charge, the charge current value lowers with a rise in the voltage of each of the battery cells 4, of course.

Thus, to determine whether or not full charging work is complete, more particularly, various methods such as a method of charging as constant-current charge and determining whether or not full charging work is complete at the time of completion of charging for a predetermined time as constant-voltage charge after the highest-voltage battery cell reaches a predetermined voltage are available. For simplicity, in the description to follow, it is assumed that full charging work is complete when the highest-voltage battery cell reaches a predetermined voltage.

Next, at step S3, the CPU 12 reads a charging rate estimation map for estimating the charging rate from the voltage of the lowest-voltage battery cell previously stored in the memory 13. After executing step S3, the CPU 12 executes step S4.

Next, at step S4, the CPU 12 references the voltage of each of the battery cells 4 of the battery pack 6 to find out the lowest-voltage battery cell, and estimates a charging rate N at the full charging time of the lowest-voltage battery cell based on the charging rate estimation map from the voltage of the lowest-voltage battery cell. After executing step S4, the CPU 12 executes step S5.

Next, at step S5, the CPU 12 calculates a correction coefficient k to make a correction so that the charging rate N of the lowest-voltage battery cell at the full charging time becomes the maximum value of remaining battery capacity display according to expression (1), and stores the calculated correction coefficient k in the memory 13. After executing step S5, the CPU 12 executes step S6.

[Expression 1]

$$k = 100/N \qquad (1)$$

Next, at step S6, the CPU 12 multiplies a charging rate N' of the lowest-voltage battery cell when the remaining battery capacity is displayed by the correction coefficient k stored in the memory 13 to calculate a charging rate n for displaying the remaining battery capacity of the battery pack 6. After executing step S6, the CPU 12 executes step S7.

Last, at step S7, the CPU 12 displays the remaining battery capacity on the combination meter 9 based on the charging rate n for displaying the lowest-voltage battery cell. After this, the CPU 12 calculates the charging rate n for displaying the lowest-voltage battery cell using the correction coefficient k stored in the memory 13 and displays the remaining battery capacity on the combination meter 9 based on the charging rate n for displaying the lowest-voltage battery cell until the next full charging time.

As described above, the remaining battery capacity display method and the remaining battery capacity display unit according to embodiment, if the voltage varies from one battery cell 4 to another battery cell 4 in the battery pack 6, the remaining battery capacity of the battery pack 6 at the full charging determination time can always be displayed as the maximum value of the remaining battery capacity meter.

According to an aspect of the invention, there can be provided a remaining battery capacity display method and a remaining battery capacity display unit capable of always displaying the remaining battery capacity of the battery pack at the full charging determination time as the maximum value of a remaining battery capacity meter.

The invention can be used for a remaining battery capacity display method and a remaining battery capacity display unit for displaying the remaining battery capacity of a battery pack including a plurality of battery cells connected in series.

**Claims**

1.   A method of displaying a remaining battery capacity of a battery pack including a plurality of battery cells connected in series, the method comprising:

monitoring at least voltage of each of the plurality of battery cells;
outputting voltage information on the monitored voltage;
when the battery pack is charged, determining whether or not the battery pack is fully charged;
when it is determined that the battery pack is fully charged, defining, as a lowest-voltage battery cell, one of the plurality of battery cells which has the lowest voltage among the plurality of battery cells;
estimating a charging rate of the lowest-voltage battery cell at a time when the battery pack is fully charged based on a charging rate map and the voltage information;
calculating a correction coefficient for making a correction so that the estimated charging rate becomes a maximum value of the remaining battery capacity at a time when the remaining battery capacity is displayed;
calculating a charging rate to be displayed, based on a charging rate of the lowest-voltage battery cell at the time when the remaining battery capacity is displayed and the calculated correction coefficient; and
displaying, as the remaining battery capacity of the battery pack, the calculated charging rate on a display.

2.   A unit of displaying a remaining battery capacity of a battery pack including a plurality of battery cells connected in series, the unit comprising:

a cell monitor, configured to monitor at least voltage of each of the plurality of battery cells and to output voltage information on the monitored voltage;
a full charging determiner, configured to determine whether or not the battery pack is fully charged when the battery pack is charged; and
a processor:

configured to define, as a lowest-voltage battery cell, one of the plurality of battery cells which has the lowest voltage among the plurality of battery cells when the full charging determiner determines that the battery pack is fully charged;
configured to estimate a charging rate of the lowest-voltage battery cell at a time when the battery pack is fully charged based on a charging rate map and the voltage information;
configured to calculate a correction coefficient for making a correction so that the estimated charging rate becomes a maximum value of the remaining battery capacity at a time when the remaining battery capacity is displayed;
configured to calculate a charging rate to be displayed, based on a charging rate of the lowest-voltage battery cell at the time when the remaining battery capacity is displayed and the calculated correction coefficient; and
configured to display, as the remaining battery capacity of the battery pack, the calculated charging rate on a display.

FIG.1

FIG.2

FIG.3

```
                    ┌─────────┐
                    │  START  │
                    └─────────┘
                         │
                         │←───────────────┐
         ┌──────────────────────────┐     │
    S1   │ START TO MONITOR VOLTAGE │     │
         │ OF EACH BATTERY CELL     │     │
         └──────────────────────────┘     │
                         │                 │
                         ▼                 │
    S2              ╱─────────╲            │
              ╱─────────────────────╲  NO  │
             ⟨   IS FULL CHARGING    ⟩─────┘
              ╲   WORK COMPLETE?    ╱
                ╲─────────────────╱
                         │
                        YES
                         ▼
         ┌──────────────────────────┐
    S3   │ READ CHARGING RATE       │
         │ ESTIMATION MAP OF LOWEST-│
         │ VOLTAGE BATTERY CELL     │
         └──────────────────────────┘
                         │
                         ▼
         ┌──────────────────────────┐
    S4   │ ESTIMATE CHARGING RATE N │
         │ AT FULL CHARGING TIME OF │
         │ LOWEST-VOLTAGE           │
         │ BATTERY CELL             │
         └──────────────────────────┘
                         │
                         ▼
         ┌──────────────────────────┐
    S5   │ CALCULATE AND STORE      │
         │ CORRECTION COEFFICIENT k │
         └──────────────────────────┘
                         │
                         ▼
         ┌───────────────────────────────────┐
    S6   │ MULTIPLY CHARGING RATE N' OF LOWEST-│
         │ VOLTAGE BATTERY CELL BY CORRECTION │
         │ COEFFICIENT k TO CALCULATE CHARGING│
         │ RATE n FOR DISPLAYING              │
         └───────────────────────────────────┘
                         │
                         ▼
         ┌──────────────────────────┐
    S7   │ DISPLAY CHARGING RATE n FOR│
         │ DISPLAYING LOWEST-VOLTAGE │
         │ BATTERY CELL              │
         └──────────────────────────┘
```

FIG.4

1 OPERATING UPPER
LIMIT VOLTAGE

2 VOLTAGE OF LOWEST-VOLTAGE
BATTERY CELL AT FULLY
CHARGING TIME

4 RANGE IN WHICH BATTERY
PACK CAN BE USED

3 OPERATING LOWER
LIMIT VOLTAGE

1    2    3       n-2  n-1  n

5 EACH BATTERY CELL
IN BATTERY PACK

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

•   JP 3390559 B